# EUROPEAN PATENT APPLICATION

(11) **EP 4 765 197 A1**
(43) Date of publication of application: **24.06.2026**
(21) Application number: 24220988.0
(22) Date of filing: 18.12.2024
(51) Int. Cl.: H01L 21/67

(54) **SYSTEMS AND METHODS FOR AN APPARATUS FOR JOINING SUBSTRATES**

(71) Applicant: ASML Netherlands B.V., 5500 AH Veldhoven (NL)
(72) Inventor: BEUKMAN, Arjan, Johannes, Anton, 5500 AH Veldhoven (NL); BLEEKER, Arno, Jan, 5500 AH Veldhoven (NL)
(74) Representative: ASML Netherlands B.V.

(57) **Abstract**

The present disclosure relates to a method. The method may comprise providing an apparatus. The apparatus may be configured to join a first substrate and a second substrate. The apparatus may comprise a stage for supporting the first substrate and a support structure for supporting the second substrate. The method may comprise contacting an inspection surface using a marker associated with the stage to impart a mark to the inspection surface. The inspection surface may be a surface of a substrate supported on the support structure or a surface of the support structure. The method may further comprise inspecting the mark to determine a position of the mark.

## Description

### TECHNICAL FIELD

The present disclosure relates generally to an apparatus configured to join a first substrate and a second substrate, and methods for the apparatus.

### BACKGROUND

In manufacturing processes of integrated circuits (ICs), multiple substrates (which may be finished or unfinished ICs, e.g., whole wafers, diced wafers, partially diced wafers, chips, die, etc.) may be placed in contact, stacked, bonded, or otherwise joined (e.g., to heterogeneous or homogeneous devices) at various points in the fabrication process. Heterogeneous integration, e.g., the integration of different circuits or other patterned devices, may rely upon joining of specific portions (for example, conductive contact elements) of multiple substrates. These specific portions may be aligned in three-dimensional space to ensure functional connectivity.

Alignment of the substrates, which may each have multiple fabrication layers, different critical dimensions, different nodes, packaging, etc., may require different techniques than those used for lithography during fabrication. As the physical sizes of IC components continue to shrink, and their structures continue to become more complex, accuracy in integration is becoming more important.

In the context of semiconductor manufacture, improvements in substrate placement and alignment during joining operations (e.g., improvements in heterogeneous integration) lead to improvements in the overall IC manufacturing process. For example, throughput of the manufacturing process may be improved (e.g. because of a reduction in the number of defective devices formed).

### SUMMARY

According to an embodiment, there is provided a method. The method may comprise using an apparatus. The apparatus may be configured to join a first substrate and a second substrate. The apparatus may comprise a stage for supporting the first substrate and a support structure for supporting the second substrate. The method may comprise contacting an inspection surface using a marker associated with the stage to impart a mark to the inspection surface. The inspection surface may be a surface of a substrate supported on the support structure or a surface of the support structure. The method may further comprise inspecting the mark to determine a position of the mark.

According to an embodiment, there is provided an apparatus configured to perform the method described above.

According to an embodiment, there is provided a computer program comprising instructions which, when executed by a processor, cause an apparatus to perform the method described above.

According to an embodiment, there is provided an apparatus configured to join a first substrate and a second substrate. The apparatus may comprise one or more of: a stage for supporting the first substrate; a marker associated with the stage; a support structure for supporting the second substrate; a measurement system; and a processor. The marker may be configured to contact an inspection surface to impart a mark to the inspection surface. The inspection surface may be a surface of a substrate supported on the support structure or a surface of the support structure. The measurement system may be configured to inspect the mark. The processor may be configured to determine a position of the mark based on the inspection of the mark.

By inspecting the mark to determine a position of the mark, information pertaining to the relative position of the stage and the support structure when the mark was imparted to the inspection surface is obtained. This information may allow errors within the apparatus (e.g. errors relating to a positioning system for the stage and/or a positioning system for the support structure) to be assessed. Additionally or alternatively, said information may allow the apparatus (e.g. a positioning system for the stage and/or a positioning system for the support structure) to be calibrated to a high degree of accuracy. Thus, by obtaining information pertaining to the relative position of the stage and the support structure when the mark was imparted to the inspection surface by inspecting the mark on the inspection surface, the apparatus is able to join the first substrate and the second substrate together more accurately (e.g. with improved alignment).

### BRIEF DESCRIPTION OF THE DRAWINGS

The accompanying drawings, which are incorporated in and constitute a part of the specification, illustrate one or more embodiments and, together with the description, explain these embodiments. Embodiments of the invention will now be described, by way of example only, with reference to the accompanying schematic drawings in which corresponding reference symbols indicate corresponding parts. The accompanying schematic drawings include the following.
Figures 1A-1D are schematic diagrams illustrating an exemplary die bonding method.
Figure 2 is a schematic diagram illustrating a bonding tool.
Figures 3A-3C schematically depict the imparting of a mark on a deformable layer on a substrate.
Figure 4 schematically depicts an example of a mark.
Figures 5A and 5B schematically depict examples of marks.
Figure 6 schematically depicts a stage and a marker die supported thereon.
Figure 7 schematically depicts a stage comprising a marker.

### DETAILED DESCRIPTION

Embodiments of the present disclosure are described in detail with reference to the drawings, which are provided as illustrative examples of the disclosure so as to enable those skilled in the art to practice the disclosure. Notably, the figures and examples below are not meant to limit the scope of the present disclosure to a single embodiment, but other embodiments are possible by way of interchange of some or all of the described or illustrated elements. Moreover, where certain elements of the present disclosure can be partially or fully implemented using known components, only those portions of such known components that are necessary for an understanding of the present disclosure will be described, and detailed descriptions of other portions of such known components will be omitted so as not to obscure the disclosure.

Embodiments described as being implemented in software should not be limited thereto, but can include embodiments implemented in hardware, or combinations of software and hardware, and vice-versa, as will be apparent to those skilled in the art, unless otherwise specified herein. In the present specification, an embodiment showing a singular component should not be considered limiting; rather, the disclosure is intended to encompass other embodiments including a plurality of the same component, and vice-versa, unless explicitly stated otherwise herein. Moreover, applicants do not intend for any term in the specification or claims to be ascribed an uncommon or special meaning unless explicitly set forth as such. Further, the present disclosure encompasses present and future known equivalents to the known components referred to herein by way of illustration.

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc.

The skilled artisan will appreciate that, in the context of such alternative applications, any use of the terms "wafer" or "die" in this text should be each considered as interchangeable with the more general term "substrate". The term "wafer" may be used generally to refer to a large unit of manufacture (which may be the largest unit of manufacture), while the term "die" may be used to refer to a smaller unit of manufacture which may correspond to a lithography pattern, a portion of a lithography pattern, multiple lithography patterns, etc. A "die" may correspond to a portion of "wafer" - that is a "die" may be produced by dicing or otherwise dividing a "wafer". The term "die" should be considered as interchangeable with the term chip, chiplet, or other terms for IC divisions.

A patterning apparatus (for example, a lithographic apparatus) can comprise, or can form, one or more patterns, which may correspond to one or more die. The patterns can be generated utilizing CAD (computer-aided design) programs, based on a pattern or design layout, this process often being referred to as EDA (electronic design automation).

As used throughout this application "or", unless indicated otherwise, takes a non-exclusive meaning, e.g., encompassing both "and" and "or".

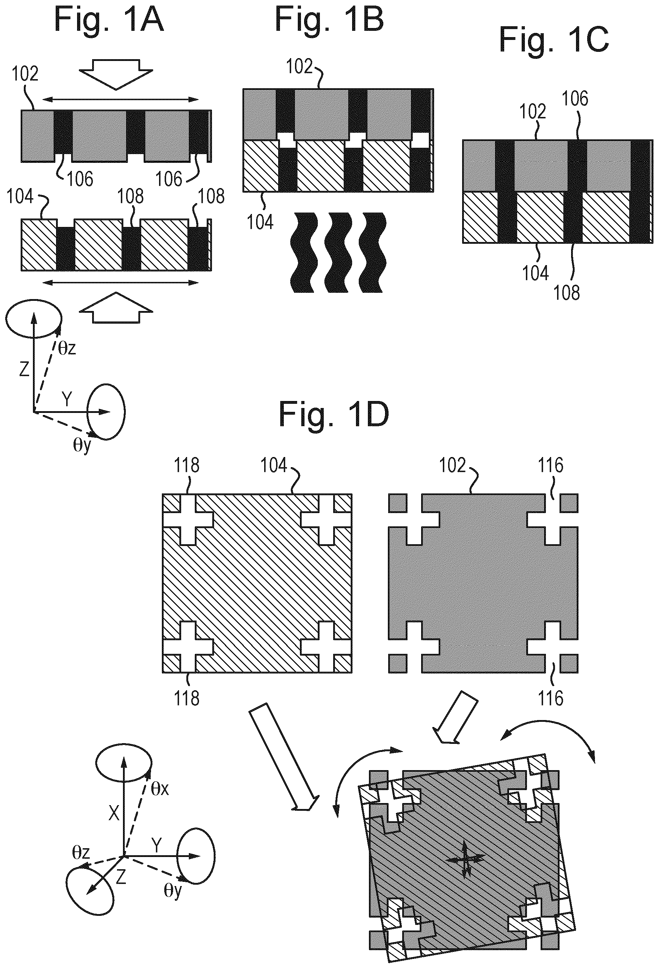

Reference is now made to Figures 1A-1D, which are schematic diagrams illustrating an exemplary die bonding method consistent with embodiments of the present disclosure. The die bonding method comprises bonding one die to another die. As will be appreciated, the bonding technique may be applied to bond any substrate (e.g. a whole wafer, a diced wafer, a partially-diced wafer, a chip, a die, etc.) to any other substrate (e.g. a whole wafer, a diced wafer, a partially-diced wafer, a chip, a die, etc.). For example, the bonding technique may be used to bond a die to another die, where the another die is a part of a wafer.

As shown in Figures 1A-1D, the exemplary die bonding method may involve a donor die 102 and a target die 104. Herein, the term "donor" and the term "target" are used for ease of description. It should be understood that the term "donor" and the term "target" are provided for reference and are relative and that elements described as corresponding to a "donor" can instead correspond to a "target" and vice versa.

The exemplary die bonding method is depicted in relation to a reference set of axes. The reference axes are provided for ease of description only and are not to be taken as limiting. Included methods and apparatuses can instead be described with reference to a different set of axes (e.g., cylindrical coordinates, polar coordinates, etc.), a different origin point (e.g., an origin point in the donor die, an origin point in the target, origin point in between the donor die and target, etc.), or a different orientation. The standard set of axes is chosen such that the fabrication plane of the die (i.e., a wafer surface) lies in the x-y plane and where the fabrication direction is parallel or antiparallel to the z-axis for both the donor die and target die.

The donor die 102 may have electrically active areas 106. The electrically active areas 106 may correspond to vias (e.g., through silicon vias (TSVs)), electrical contact lines, contact pads, packaging pads, or other electrically conductive areas. The donor die 102 may have one or more electrically inert areas (for example, electrically insulating areas or dielectric areas) outside of the electrically active areas 106. The electrically active areas 106 may be recessed (as shown) with respect to other surfaces of the donor die 102. The electrically active areas 106 may correspond to contacts (e.g., to source, to drain, to gate, etc.) to electrical devices within the donor die 102 (not shown). The target die 104, likewise, may have electrically active areas 108, which may have similar properties to the electrically active areas 106.

Figures 1A-1C depict a cross-sectional view of portions of the exemplary die bonding method. As shown in Figure 1A, the exemplary die bonding method may involve alignment of at least some of the electrically active areas 106 of the donor die 102 with at least some of the electrically active areas 108 of the target die 104. The exemplary die bonding method may involve bringing the donor die 102 into contact with the target die 104 while maintaining alignment between the electrically active areas 106 in the electrically active areas 108. As further shown in Figure 1A, the donor die 102 and the target die 104 may be brought together along the z-axis, while the position of the donor die 102 and/or the target die 104 may be adjusted in the x-y plane (e.g., perpendicular to the z-axis of approach). The alignment may be complicated by the multiple layers of the donor die 102 or the multiple layers of the target die 104, which may be optically opaque.

Upon bringing the donor die 102 into contact with the target die 104, an initial bond may be formed between the donor die 102 and the target die 104. The initial bond may be between dielectric areas of the donor die 102 and dielectric areas of the target die 104. The initial bond may comprise intermolecular forces, such as Van der Waal's forces and the like.

As shown in Figure 1B, the donor die 102 and the target die 104 may be annealed after contact. Annealing may be or include heat annealing, electrical annealing, electrostatic processes, etc. As shown in Figure 1C, annealing may cause physical or chemical changes in the electrically active areas 106 of the donor die 102 or in the electrically active areas 108 of the target die 104 which may cause physical contact or electrical contact between the electrically active areas 106 and the electrically active areas 108. Annealing may therefore produce electrical connectivity between elements of the donor die 102 and the target die 104 (e.g., integration). This electrical connectivity may occur even if the electrically active areas 106 and the electrically active areas 108 differ - for example, have different recessed depths, are made up of different materials, have different dimensions, etc.

Figure 1D depicts a plan view of an example die bonding method according to this disclosure. As shown in Figure ID, the donor die 102 and the target die 104 may have alignment marks along the x-y plane to facilitate alignment of the die as a whole. Alignment marks in the x-y plane of die (e.g., alignment marks 116 on the donor die 102 or alignment marks 118 on the target die 104) may reduce the area available for circuitry. Alignment marks may be additively or subtractively fabricated, such as by etching or deposition in the z-direction.

Alignment marks (such as alignment marks used for alignment of one or more fabrication layer during lithography) used during fabrication of wafers may be placed in waste areas, such as areas between chips, which may then be destroyed (e.g., removed) during dicing. Dicing herein refers to mechanical separation of areas of a wafer (e.g., a unit of manufacture) into smaller areas (e.g., dies or chips) which may contain one or more units of operation (e.g., a logic device, a memory unit, etc.). Dicing may operate using any appropriate method - for example, scribing and breaking, mechanical sawing, laser cutting, etc. - and may destroy (e.g., grind to powder or otherwise render inoperable for circuitry placement) a non-zero linewidth portion of the wafer volume when separating die.

The electrically active areas 106 of the donor die 102 or the electrically active areas 108 of the target die 104 (not shown in Figure 1D) or other surface features may function as reference marks for alignment (e.g., alignment marks) of the donor die 102 and the target die 104. The donor die 102 and the target die 104 may be aligned in three dimensions before or during contact between the donor die 102 and the target die 104. For example, the donor die 102 or the target die 104 may be positioned or adjusted in the x-y plane as the donor die 102 in the target die 104 are contacted. The donor die 102 or the target die 104 may be positioned or adjusted by operation of a die actuator or other die-scale elements, such as by piezoelectric stepper elements, or by operation of a wafer chuck or other wafer-scale elements, such as by stepper elements.

The position of the donor die 102 or the target die 104 may be adjusted with respect to up to six degrees of freedom. For example, given an origin point at the center of the donor die 102, the donor die 102 may be adjusted by movement along the x-axis (e.g., in a positive or negative X direction), along the y-axis (e.g. in a positive or negative Y direction), along the z-axis (e.g., in a positive or negative Z direction). The donor die 102 may also be adjusted rotationally with respect to each of those axes - e.g., rotated with respect to the x-axis, rotated with respect to the y-axis, rotated with respect to the z-axis. That is, the donor die 102 may be adjusted by free rotation in space accounted for by six different types of movement (where the movements listed above are provided as examples but where the movements may be described by other axes).

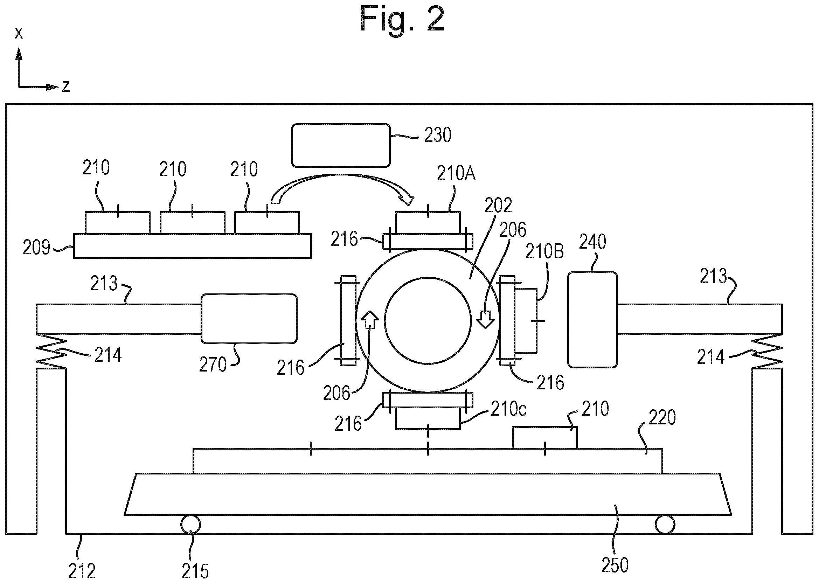

Figure 2 is a schematic diagram illustrating a bonding tool for the placement of donor substrates 210 onto an acceptor substrate 220 by a moveable stage 202. Figure 2 is described with reference to "donor" substrates 210 (e.g. donor substrates 210A-210C) and "acceptor" substrates 220, which are relative descriptors - a donor substrate may instead be an acceptor substrate, and vice-versa. The bonding tool depicted in Figure 2 may be configured to place any donor substrate (e.g. a whole wafer, a diced wafer, a partially-diced wafer, a chip, a die, etc.) onto any target substrate (e.g. a whole wafer, a diced wafer, a partially-diced wafer, a chip, a die, etc.). For example (and as depicted in Figure 2), the bonding tool may be configured to place a donor die 210 onto an acceptor wafer 220.

The acceptor substrate 220 may comprise one or more target portions. For example, the acceptor substrate 220 may comprise one or more target dies formed therein (prior to being diced/separated). The method/apparatus depicted in Figure 2 may be to place a donor die 210 onto a target die of the acceptor wafer 220. In the case that the acceptor wafer 220 comprises a plurality of target dies, the method may be repeated such that each donor die 210 is placed onto one of the plurality of target dies on the acceptor wafer 220.

The placing of a donor substrate 210 onto an acceptor substrate 220 may be a part of a bonding process comprising bonding the donor substrate 210 and the acceptor substrate 220 together. The bonding between the donor substrate 210 and the acceptor substrate 220 may be the same, or similar to, the bonding described with reference to Figure 1.

The stage 202 may be substantially circular in the x-z plane, with a longitudinal axis along the y-direction (e.g. the stage 202 may be substantially cylindrical in three dimensions). The stage 202 may instead have a different cross-sectional shape, such as square, hexagonal, etc. The stage 202 may have a symmetrical (e.g., as shown) cross-section with one or more axis of symmetry, or asymmetrical cross-sectional area (for example, an irregular polygon).

The stage 202 may comprise receiver portions 216. The receiver portions 216 each may be, or may comprise, a recess. The receiver portions 216 may each be configured to receive and/or accept and/or support and/or hold and/or clamp a donor substrate 210. The receiver portions 216 may each be configured to clamp a donor substrate 210 thereto using a vacuum clamping means and/or an electrostatic clamping means.

The placement of the receiver portions 216 may be symmetrical or asymmetrical around the cross-sectional area of the stage 202. The stage 202 may have a substantially symmetrical cross-section but have asymmetric placement of receiver portions 216. For example, the stage 202 may have a cross-section that is a regular hexagon but have receiver portions 216 placed asymmetrically along longitudinal faces.

The stage 202 may be a moveable stage, e.g. a rotatable stage. The stage 202 may be controllably moved (e.g. rotated) in a direction 206 about the longitudinal axis. The direction 206 is provided as an example. The stage 202 may instead be rotated in an opposite direction or any appropriate direction, translated along the x, y, or z direction or any combination thereof. The stage 202 may be operated in both rotational and translational modes, including sequentially or at the same time. F or example, the stage 202 may move in the negative x-direction towards a support structure 250 while also rotating about the longitudinal axis. The stage 202 may move continuously or intermittently. For example, the stage 202 may rotate in the direction 206 and stop at four (or fewer or more) positions corresponding to operations in the placement of the donor substrate 210.

Example positions and operations will now be further discussed. These positions and operations are provided as examples only, and multiple operations may be performed at a single position, a position may not correspond to an operation (e.g., may correspond to a null operation), an operation may be performed at multiple positions (e.g., the operation may be performed multiple times or in steps divided between positions), etc. These positions and operations are described as happening in discrete positions (such as when movement of the stage 202 is substantially zero), but the positions may instead correspond to continuous (or quasi-continuous movement) or operations may occur while the stage 202 is moving in one or more directions (e.g., rotationally, translationally, etc.).

A first position, such as corresponding to the position depicted for the donor substrate 210A, may correspond to placement of a donor substrate 210A in a receiver portion 216 of the stage 202. The donor substrate 210A may be placed on the receiver portion 216 by a pick and place element 230. The pick and place element 230 may place the donor substrate 210A on the stage 202 on the receiver portion 216 based on alignment information, based on positional information of the stage 202, etc. The pick and place element 230 may place the donor substrate 210A on the support structure at a given position relative to the receiver portion 216. For example, the pick and place element 230 may center the donor substrate 210A relative to the receiver portion 216.

The second position, such as corresponding to the position depicted for the donor substrate 210B, may correspond to measurement of the position of the donor substrate 210B relative to the receiver portion 216 of the stage 202. The position (e.g., location) of the donor substrate 210B may be measured by a location measurement element 240. The location measurement element 240 may measure an actual position of the donor substrate 210B, in relative (such as relative to the receiver portion 216) or absolute terms (such as in distances from an origin point on the stage 202, on the location measurement element 240, etc.).

The location measurement element 240 may be a camera, e.g., a two-dimensional camera, two or more one-dimensional cameras, an optical camera, etc., or another measurement device. The location measurement element 240 may be made up of multiple location measurement elements, such as an in-plane measurement device which may measure locations in the y-z plane (relative to the reference axes) and an out-of-plane measurement device which may measure locations or distances in the x direction (relative to the reference axes). The location measurement element 240 may include one or more confocal microscopes, which may measure depth (or other distance). The location measurement element 240 may measure position, relative or absolute position, using overlay diffraction or other diffraction-based methods. The location measurement element 240 may operate in a scanning mode or from a fixed position relative to the stage 202.

Once the position of the donor substrate 210B is measured, the stage 202 may move (e.g., rotate in the direction 206), so that the donor substrate 210B occupies the position of the donor substrate 210C, which may be a third position of the stage 202. The third position of the support structure will now be described with reference to the donor substrate 210C.

The third position, such as corresponding to the position depicted for the donor substrate 210C, may correspond to placement of the donor substrate 210C on the acceptor substrate 220. The acceptor substrate 220 may comprise a target portion (e.g. a target die, as described above). The bonding tool may be configured to place the donor substrate 210C at the target portion of the acceptor substrate 220 by bringing the donor substrate 210C into contact with the target portion of the acceptor substrate 220. As the donor substrate 210C is brought into contact with the target portion of the acceptor substrate 220, initial bonding forces (e.g. Van der Waal's forces and the like) may be formed between the donor substrate 210C and the acceptor substrate 220.

The acceptor substrate 220 may be supported by the support structure 250. The donor substrate 210C may be brought into contact with the acceptor portion by motion of the stage 202 towards the support structure 250, motion of the support structure 250 towards the stage 202, or a combination thereof. Motion of the stage 202 towards the support structure 250 may comprise movement in the z-direction. Motion of the stage 202 towards the support structure 250 may comprise movement of the whole stage 202 towards the support structure 250. Motion of the stage 202 towards the support structure 250 may comprise movement of the receiver portion 216 in the third position towards the support structure 250 (i.e. movement of the receiver portion 216 in the third position relative to a main body of the stage 202). Motion of the stage 202 towards the support structure 250 may comprise a combination of movement of the whole stage 202 and movement of the receiver portion 216 in the third position relative to the main body of the stage 202. Motion of the support structure 250 towards the stage may comprise movement in the z-direction.

Once the donor substrate 210C is placed on the acceptor substrate 220, the stage 202 and the support structure 250 may operate (individually or in concert) to place at least one additional donor substrates on the acceptor substrate 220. For example, the stage 202 and the support structure 250 may move relative to one another in the x- or y-direction so that another part of the acceptor substrate 220 is proximate to the stage 202 (e.g. so that another target portion of the acceptor substrate 220 is aligned with the stage 202). The relative motion of the stage 202 and the support structure 250 may be caused by movement of the support structure 250 (e.g. by the positioning system for the support structure 250).

After placing the donor substrate 210C onto the acceptor substrate 220, the stage 202 may rotate to align the next donor substrate on the stage (i.e. the donor substrate 210B) with the acceptor substrate 210. Generally, the stage 202 may be rotatable to align different donor substrate 210 (and/or different receiver portions 216 of the plurality of receiver portions 216) with the acceptor substrate 220.

A direction of gravity is not depicted, but the placement of the donor substrate 210C on the acceptor substrate 220 may experience gravitation effects. For example, the placement of the donor substrate 210C on the acceptor substrate 220 may be encouraged by gravity (e.g., occur in the direction of gravity) or be retarded by gravity (e.g., occur opposite the direction of gravity). Gravitational effects may be balanced by clamps, suction, vacuum, and other forces.

The stage 202 may comprise an actuator (not shown). The actuator may be configured to cause the stage 202 to accept the donor substrates 210 from the pick & place element 230 and subsequently transport the donor substrates 210 to location measurement element 240 and finally place the donor substrates 210 on the acceptor substrate 220. The actuator may be configured to rotate the stage 202 in the manner described above.

The support structure 250 may be configured to move the acceptor substrate 220 with high accuracy. The bonding tool may comprise a base frame 212. As shown in Figure 2, the support structure 250 that supports the acceptor substrate 220 may be coupled to the base frame 212 by at least one bearing 215. The support structure 250 may comprise a plurality of stages that may be stacked relative to each other via a plurality of bearings.

For example, the support structure 250 may comprise a long stroke module for relatively coarse positioning of the acceptor substrate 220 over a longer distance, and a short stroke module for higher accuracy positioning of the acceptor substrate 220 over a shorter distance. The short stroke module may be stacked on the long stroke module. The short stroke module and the long stroke module may each be part of a positioning system configured to position the support structure 250 (and therefore to position the acceptor substrate 220 supported on the support structure 250) in the horizontal plane, i.e. in the x- and y-directions. The short stroke module and the long stroke module may each comprise one or more actuators configured to move the support structure 250 relative to the base frame 212. Thus, in general, the positioning system may comprise one or more actuators configured to move the support structure 250.

The positioning system may comprise one or more sensors configured to determine the position of the support structure. The one or more sensors may be interferometric sensors.

As shown in Figure 2, the bonding tool may comprise a metrology frame 213. The metrology frame 213 may be referred to as an isolated frame. The metrology frame 213 may be isolated relative to the base frame 212. The bonding tool may comprise an isolator 214. The isolator 214 may be configured to substantially isolate the metrology frame 213 from the base frame 212. By isolating the metrology frame 213 from the base frame 212, vibrations of the base frame 212 may have less of an effect on the metrology frame 213.

A controller may be configured to control the stage 202 and the support structure 250 so as to accurately place a donor substrate 210 onto a target portion of the acceptor substrate 220. Alignment between the donor substrate 210 and the acceptor substrate 220 in the horizontal (x and y) directions is important. This is because, as described above, the donor substrate 210 and the acceptor substrate 220 each have electrically-active areas which must come into contact with each other for the combination of the donor substrate 210 and the acceptor substrate 220 to function as intended.

To accurately align the donor substrate 210 and the acceptor substrate 220, the position of the donor substrate 210 relative to the acceptor substrate 220 may be determined. The determination of the position of the donor substrate 210 relative to the acceptor substrate 220 may be direct, indirect, explicit or implicit. For example, the actual position of the donor substrate 210 relative to the acceptor substrate 220 itself may not be explicitly determined, but another parameter which is indicative of the position of the donor substrate 210 relative to the acceptor substrate 220 may be determined (and thus the position of the donor substrate 210 relative to the acceptor substrate 220 is determined indirectly/implicitly). The determination of the position of the donor substrate 210 relative to the acceptor substrate 220 may be may be done with use of alignment marks (e.g. like the alignment marks 118, 116 depicted in Figure 1) on the donor substrate 210 and the acceptor substrate 220.

Additionally or alternatively, the position of the donor substrate 210 relative to the acceptor substrate 220 may be determined based on determining the position of the stage 202 (e.g. the position of the receiver portion 216 in the third position) relative to the support structure 250. This may be possible because the position of the acceptor substrate 220 relative to the support structure 250 is accurately known and/or the position of the donor substrate 210 relative to the stage 202 (e.g. relative to the receiver portion 216) is accurately known. The position of the receiver portion 216 in the third portion relative to the stage 202 in general may be known and fixed (e.g. because the receiver portion 216 is fixedly coupled to a main body of the stage 202). Thus, knowledge of the position of the stage 202 relative to the support structure 250 may be equivalent to knowledge of the position of the receiver portion 216 in the third position relative to the support structure, and vice-versa.

The position of the acceptor substrate 220 relative to the support structure 250 may be known through a metrology process performed by a sensor, e.g. an alignment sensor. The position of the donor substrate 210 relative to the stage 202 (e.g. relative to the receiver portion 216) may be accurately known through measurements performed by the location measurement element 240, as described above.

The alignment sensor used to obtain the position of the acceptor substrate 220 relative to the support structure 250 may be known may be an interferometric sensor. The alignment sensor may be configured to determine a position of an alignment mark (e.g. a diffraction grating) on the acceptor substrate 220 relative to a reference mark (e.g. a diffraction grating) on the support structure 250. An example of an alignment sensor is described in EP1 372 040B1, the entirety of which is hereby incorporated by reference.

The alignment sensor may be disposed in a measurement station of the bonding tool (not shown). The measurement station may be separate and/or distinct from the bonding station of the bonding tool (i.e. the station depicted in Figure 2).

The bonding tool may comprise two support structures 250, each configured to support an acceptor substrate 220. The support structures 250 may be independently moveable. The support structures 250 may each be provided with a positioning system, such as the positioning system described above. Alternatively, the bonding tool may comprise a single positioning system which is configured to move the two support structures 250 independently. The bonding tool may be configured such that one support structure 250 can be positioned in the measurement station and the other support structure 250 can be positioned in the bonding station, simultaneously. Thus, preparatory measurement processes may be performed on one acceptor substrate 220 (in the measurement station) while bonding processes are performed on another acceptor substrate 220 (in the bonding station).

The position of the stage 202 (e.g. the position of the receiver portion 216 in the third position) relative to the support structure 250 may be determined by measuring the position of the stage 202 using one measurement system, and measuring the position of the support structure 250 using another, independent measurement system (e.g. the positioning system described above). The positions of the stage 202 and the support structure 250 may be measured in different coordinate systems, and/or with respect to different references.

For the bonding tool to be able to accurately place a donor substrate 210 at a target portion of the acceptor substrate 220, the relative position of the support structure 250 and the stage 220 may need to be accurately determined based on the measured position of the stage 202 and/or the measured position of the support structure 250 (specifically, in the x- and y-directions). In some embodiments, the position of the stage 202 in the x- and y-directions may be fixed, such that the determination of the position of the stage 202 relative to the support structure 250 in the x- and y-directions is based on the measurement of the position of the support structure 250 by the positioning system. Even where the position of the stage 202 in the x- and y-directions is fixed, the stage 202 may be able to rotate to align different receiver portions 216 with the acceptor substrate 220.

The present disclosure is directed to providing techniques for obtaining information which may allow for the accuracy of the placement of a donor substrate 210 on a target portion of an acceptor substrate 220 to be increased. The information obtained may pertain to the relative position of the stage 202 and the support structure 250 at a given point in time. This information may allow errors within the bonding tool (e.g. errors relating to the measurement system used to determine the position of the stage 202 and/or the positioning system for the support structure 250) to be assessed. Additionally or alternatively, said information may allow the bonding tool (e.g. the measurement system used to determined the position of the stage 202 and/or the positioning system for the support structure 250) to be calibrated to a high degree of accuracy.

The present disclosure is, in part, directed to a method, which may be referred to as an inspection method. The inspection method may be for use with/on a bonding tool. The bonding tool may be an apparatus configured to join (e.g. bond) one substrate (i.e. a first substrate) and another substrate (i.e. a second substrate). The bonding tool may comprise a stage for supporting the first substrate and a support structure for supporting the second substrate. The bonding tool may be the bonding tool depicted in Figure 2 and described above. The method may be referred to as an inspection method.

The inspection method may comprise imparting a mark to an inspection surface using a marker, and then inspecting the mark to determine a position of the mark. The marker may be associated with the stage 202. For example, the position of the marker relative to the stage 202 (e.g. relative to a receiver portion 216 of the stage) may be known. The position of the mark may be determined with respect to any suitable reference, e.g. with respect to the inspection substrate or with respect to the support structure 250 on which the inspection substrate is supported. The inspection surface may be associated with the support structure 250. For example, the position of the inspection surface relative to the support structure 250 may be known. Thus, the position of the mark on the inspection surface may be indicative of the relative position of the stage 202 and the support structure 250 when the mark is imparted to the inspection surface.

The term "inspection" in "inspection surface" is used as a label. The inspection surface is the surface at which the mark is imparted as part of the inspection method. The inspection surface may be: (i) a surface of an inspection substrate supported on the support structure, and/or (ii) a surface of the support structure 250 itself.

In the present disclosure, the term "inspection" in "inspection substrate" is used as a label. The inspection substrate is a substrate which is used in the inspection method. The inspection substrate may be supported on the support structure 250 in the same, or a substantially similar, way as the acceptor substrate 220 is supported on the support structure 250. The inspection substrate may be substantially similar to the acceptor substrate 220. For example, the inspection substrate may be a wafer supported on the support structure 250. The inspection substrate may be a test substrate (e.g. a test wafer), which is specifically adapted for use in the inspection method. The inspection substrate may be a production substrate (e.g. a production wafer), which is configured to be made into an integrated circuit (IC). The position of the inspection substrate relative to the support structure 250 may be determined through a measurement process performed by an alignment sensor, as described above.

For the case that the inspection surface is a surface of the support structure 250 itself, any surface which has a fixed positional relationship to the support structure 250 may be considered to be a surface of the support structure. For example, a surface of a component which is mechanically secured to the support structure 250 (e.g. a component which is bolted to the support structure 250 or equivalent) may be considered to be a surface of the support structure 250. The inspection surface may be a reserved surface of the support structure 250, i.e. a surface of the support structure which is specifically designated for being used in the inspection method described herein. The use of the reserved surface of the support structure 250 for the inspection method may not interfere with the main functionality of the support structure (i.e. supporting acceptor substrates 220). For example, the reserved surface of the support structure 250 may be a non-critical surface of the support structure 250 (e.g. a part of the support structure 250 not used for holding or clamping a substrate).

The techniques of the present disclosure are described primarily in relation to the case that the inspection surface is a surface of an inspection substrate supported on the support structure 250. However, as will be appreciated, the techniques described are equally applicable to the case that the inspection surface is a surface of the support structure 250 itself.

In the inspection method, the marker may contact (e.g. come into direct physical contact with) the inspection surface to impart the mark to the inspection surface. The imparting of the mark to the inspection surface may comprise imprinting the mark at the inspection surface. That is, in the inspection method, the mark may be formed at the inspection surface by an imprinting process. The imprinting of the mark may be performed using the marker.

Additionally or alternatively, the imparting of the mark to the inspection surface may comprise burning or scorching the mark into the inspection surface, e.g. by bringing a heated marker into contact with the inspection surface. Additionally or alternatively, the imparting of the mark may comprise printing the mark onto the inspection surface with a liquid (e.g. an ink or equivalent) that is transferred from the marker to the inspection surface upon contact between the marker and the inspection surface.

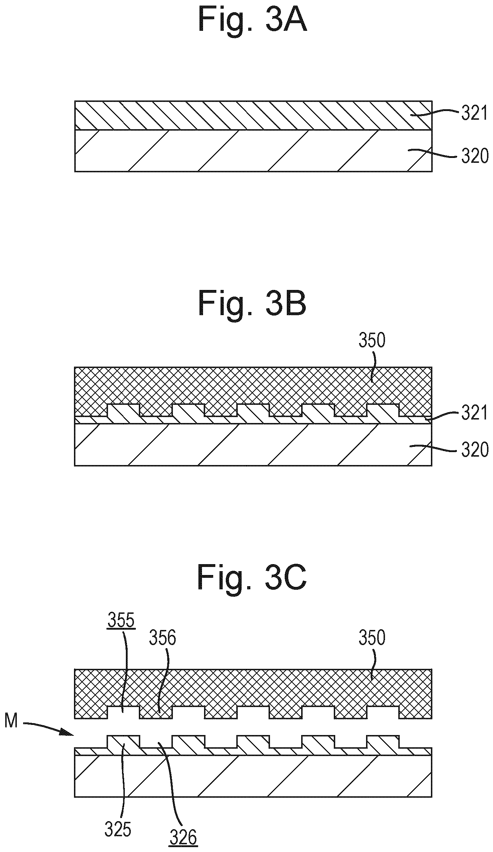

An exemplary imprinting process is schematically depicted in Figures 3A to 3C. As will be appreciated, various features described in connection with this imprinting process may be implemented in other methods for imparting a mark to the inspection surface (e.g. burning, scorching and printing).

The inspection surface may be formed by (e.g. defined by) a deformable layer 321. As a preparatory step, the deformable layer 321 may be applied to the inspection substrate 320. Once applied to the inspection substrate 320, the deformable layer 321 may be considered to be a part of the inspection substrate 320.

The mark M may be imprinted in the deformable layer 321. Imprinting the mark M in the deformable layer may result in the imparting of a mark to the inspection surface.

The mark M may be imprinted in the deformable layer by the marker 350. The marker may comprise at least one protrusion 356 configured to form an imprint in the deformable layer 321. As shown in Figures 3A to 3C, the marker 350 may comprise a plurality of protrusions 356. Recesses 355 may be defined between the plurality of protrusions 356. When the marker 350 is brought into contact with the deformable layer 321, the pattern of protrusions 356 and recesses 355 on the marker 350 may be imprinted into the deformable layer 321. Protrusions 356 on the marker 350 may correspond to recesses 326 in the mark M imprinted into the deformable layer 321. Recesses 355 on the marker may correspond to protrusions 325 in the mark M imprinted into the deformable layer 321.

As one specific example, the plurality of protrusions may be a plurality of linear, elongated protrusions 356. The plurality of linear, elongated protrusions 356 may be separated from one another in a direction that is perpendicular to the direction in which the protrusions extend. The plurality of linear, elongated protrusions 356 may define a plurality of linear, elongated recesses 355 therebetween. This may be such that the marker 350 is configured to imprint a linear diffraction grating (as the mark M) in the deformable layer 321. Generally, the arrangement of the one or more protrusions on the marker 350 may correspond to the desired features of the mark M to be imprinted in the deformable layer.

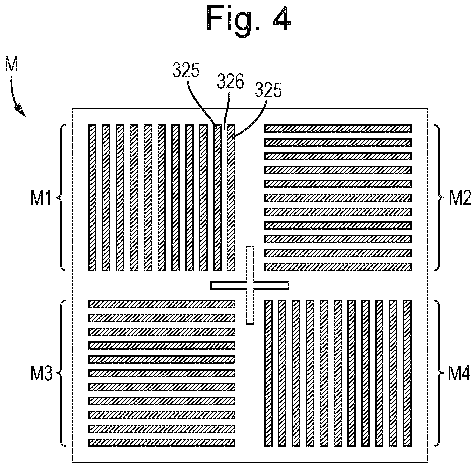

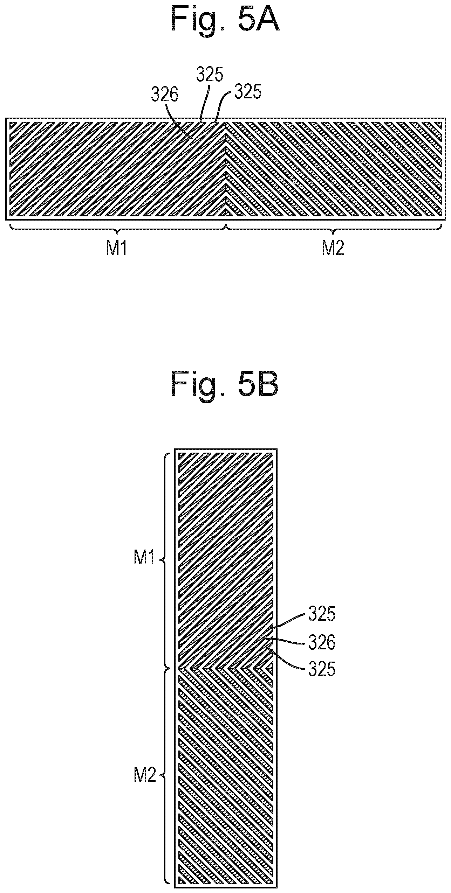

Figures 4, 5A and 5B depict other examples of marks M that may be imparted to the inspection surface by the marker 350. The mark M depicted in Figure 4 comprises four sub-marks: M1, M2, M3 and M4. The four sub-marks are arranged in a 2x2 grid. Of the two sub-marks M1, M2 in a first row, one sub-mark M1 comprises a linear diffraction grating with the elongated protrusions 325 extending in a first direction, and another sub-mark M2 comprises a linear diffraction grating with the elongated protrusions 325 extending in a second direction perpendicular to the first direction. Of the two sub-marks in a second row, one sub-mark M4 comprises a linear diffraction grating with the elongated protrusions 325 extending in the first direction, and another sub-mark M3 comprises a linear diffraction grating with the elongated protrusions 325 extending in the second direction. The sub-mark M1 in the first row with elongated protrusions extending in the first direction is in a first column. The sub-mark M4 in the second row with elongated protrusions 325 extending in the first direction is in a second column. In the mark M depicted in Figure 4, the direction in which the elongated protrusions extend is either perpendicular to or parallel to the direction in which the various sub-marks are spaced apart from one another.

In the mark M depicted in Figure 5A a first sub-mark M1 is adjacent to a second sub-mark M2 in the second direction. The elongated protrusions 325 in both the first sub-mark M1 and the second sub-mark are at an angle of approximately 45° relative to the second direction. The elongated protrusions 325 in the first sub-mark M1 are substantially perpendicular to the elongated protrusions 325 in the second sub-mark M2. In the mark M depicted in Figure 5A, the first sub-mark M1 and the second sub-mark M2 are mirror-images of each other about an axis parallel to the first direction (which, in Figure 5A, is in the vertical direction).

In the mark M depicted in Figure 5B a first sub-mark M1 is adjacent to a second sub-mark M2 in the first direction. The elongated protrusions 325 in both the first sub-mark M1 and the second sub-mark are at an angle of approximately 45° relative to the first direction. The elongated protrusions 325 in the first sub-mark M1 are substantially perpendicular to the elongated protrusions 325 in the second sub-mark M2. In the mark M depicted in Figure 5B, the first sub-mark M1 and the second sub-mark M2 are mirror-images of each other about an axis parallel to the second direction (which, in Figure 5B, is in the horizontal direction).

The deformable layer 321 may comprise a layer of photoresist. The deformable layer 321 may be the layer of photoresist (i.e. the deformable layer 321 may consist of the layer of photoresist). The imprinting of the mark in the deformable layer 321 may comprise imprinting the mark M in the layer of photoresist.

As above, the marker 350 may be associated with the stage 202 in that the position of the marker 350 relative to the stage 202 is known.

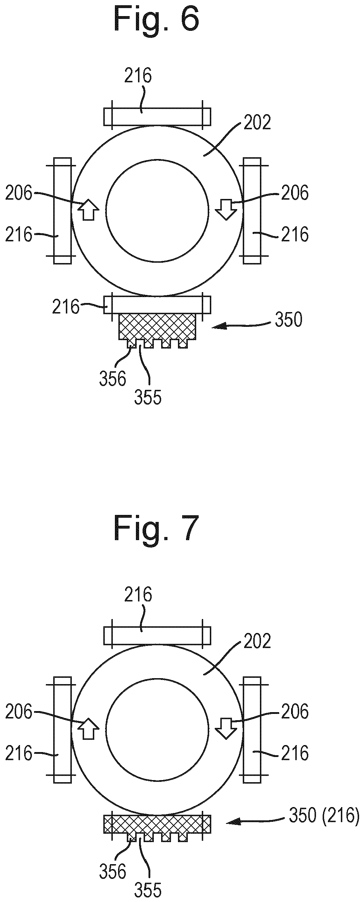

In some embodiments, a marker substrate may comprise the marker 350, e.g. the marker 350 may be a marker substrate. The marker substrate may be supported on the stage 202, as shown in Figure 6.

The marker substrate may be supported/clamped by a receiver portion 216. The marker substrate may be supported/clamped by the receiver portion in the same way as a donor substrate 210 is supported/clamped by the receiver portion 216 during the operation of the bonding tool. For example, the receiver portion 216 may support/clamp the marker substrate using a vacuum clamping means and/or an electrostatic clamping means.

The marker substrate may be a substrate with protrusions 356 provided thereon to form the marker 350. The marker substrate may be a substrate of the type that the stage 202 is configured to support/clamp. The marker substrate may be similar in structure to the type of die that the stage 202 is configured to support/clamp during the bonding method. In the bonding tool depicted in Figure 2, the donor substrate 210 may be a die and the acceptor substrate 220 may be a wafer. In this case, the marker substrate may be a marker die, i.e. a die with protrusions formed thereon.

As another example, the stage 202 may comprise the marker 350, and/or the marker 350 may be mounted on the stage 202 (i.e. directly on the stage 202). This may be such that the position of the marker 350 relative to a main body of the stage 202 is known and fixed (i.e. constant). Thus, by determining the position of the marker 350, the position of the stage 202 is known, and vice-versa.

Figure 7 depicts an example of a stage 202 of a bonding tool in which the marker 350 is an adapted receiver portion 216. For example, the marker 350 may be a receiver portion 216 comprising one or more protrusions 356 configured to imprint a mark (e.g. a diffraction grating) into a deformable layer on an inspection substrate. Alternatively, the marker 350 may be a component which is coupled to the stage 202 in place of (i.e. instead of) a receiver portion 216. The marker 350 may be coupled to the stage 202 using the same coupling means as is used to couple the receiver portions 216 to the stage 202.

To cause the marker 350 to contact the inspection surface, the marker 350 may be moved towards the support structure 250 and/or the support structure 250 may be moved towards the marker 350. Motion of the stage 202 towards the support structure 250 may be movement in the z-direction. Motion of the support structure 250 towards the stage 202 may comprise movement in the z-direction. The movement(s) which is/are performed in order to cause the marker 350 to impart the mark M to the inspection substrate may be substantially the same as the movement(s) which is/are performed to place a donor substrate 210 on an acceptor substrate 220.

Motion of the stage 202 towards the support structure 250 may comprise movement of the whole stage 202 towards the support structure 250. For the example depicted in Figure 6, motion of the stage 202 towards the support structure 250 may comprise moving the receiver portion 216 to which the marker substrate is clamped towards the inspection substrate (i.e. moving said receiver portion 216 relative to the main body of the stage 202). For the example depicted in Figure 7, motion of the stage 202 towards the support structure 250 may comprise moving the marker 350 towards the inspection substrate (i.e. moving said marker 350 relative to the main body of the stage 202).

The position of the marker 350 relative to the stage 202 (and, in particular, the position of the marker 350 relative to the stage 202 in directions parallel to the plane in which the marker 350 extends) may be known as a result of the mechanical coupling between the marker 350 and the stage 202. Additionally or alternatively, the position of the marker 350 relative to the stage 202 (and, in particular, the position of the marker 350 relative to the stage 202 in directions parallel to the plane in which the marker 350 extends) may be determined, e.g. using the location measurement element 240. This applies to the examples depicted in Figures 6 and 7.

The location (e.g. the absolute location, e.g. with reference to a fixed, external reference point) of the stage 202 when the mark is imparted to the inspection surface may be referred to as an imparting location for the stage 202. The location (e.g. the absolute location, e.g. with reference to a fixed, external reference point) of the support structure 250 when the mark is imparted to the inspection surface may be referred to as an imparting location for the support structure 250.

The method may comprise recording one or more measurements pertaining to the location of the support structure 250 while the support structure 250 is at the imparting location. Said one or more measurements may be made by the one or more sensors of the positioning system for the support structure 250. Additionally or alternatively, the method may comprise recording one or more measurements pertaining to the location of the stage 202 while the stage 202 is at the imparting location. The measurements of the position of the support structure 250 and/or the stage 202 while the stage 202 and/or the support structure 250 are at their respective imparting locations may be stored for use in an accuracy determination processing or a calibration processing, which will be described in further detail below.

After the mark M has been imparted to the surface of the inspection substrate, the mark M may be inspected to determine the position of the mark M. The inspection of the mark may comprise inspecting the one or more diffraction gratings which form the mark M. The inspection may be performed using an interferometric measurement system. For example, the inspection may be performed using an alignment sensor. The alignment sensor may be configured to determine a position of the imparted mark M (e.g. a diffraction grating of the mark M) on the inspection surface relative to a reference mark (e.g. a diffraction grating) on the support structure 250. An example of an alignment sensor is described in EP1 372 040B1, the entirety of which is hereby incorporated by reference. The alignment sensor used to determine the position of the imprinted mark M may be the same alignment sensor that is used to determine the position of substrates supported on the support structure 250 relative to the support structure 250 (e.g. to determine the position of acceptor substrates 220 relative to the support structure 250), as described above. However, this is not essential, and different alignment sensors may be provided for the different position determination processes.

The alignment sensor that is used to determine the position of the imparted mark M may be disposed in the measurement station of the bonding tool (not shown). As above, the measurement station may be separate and/or distinct from the bonding station of the bonding tool (i.e. the station depicted in Figure 2). Thus, the inspection method may comprise: imparting the mark M to the inspection surface at the bonding station; moving the support structure 250 (with the inspection substrate supported thereon) from the bonding station to the measurement station; and then inspecting the mark M to determine the position of the mark at the measurement station.

After the inspecting of the mark to determine the position of the mark, the deformable layer 321 may be removed from the inspection substrate. The inspection substrate may then be used again. For example, a new deformable layer may be applied to the inspection substrate in the future, and the inspection substrate may be used again in an inspection method. That is, the same inspection substrate may be re-used in a plurality of iterations of the inspection method. Thus, the inspection method described herein is economical, and avoids wastage.

For the case that the inspection surface is a surface of the support structure 250 itself, after the inspecting of the mark to determine the position of the mark, the deformable layer 321 may be removed from the support structure 250.

The method described herein may provide one or more outputs, including: (i) the position of the imparted mark M as determined by inspection of the mark (e.g. using the alignment sensor); (ii) the measured location of the support structure 250 while the support structure 250 is at the imparting location; and (iii) the measured location of the stage 202 while the stage 202 is at the imparting location. In some cases, (iii) may not be an output of the method. For example, the location of the stage 202 may be fixed (i.e. constant). Thus, the location of the stage 202 (e.g. position of the stage 202 while the stage 202 is at the imparting location for the stage 202) may be known, but not because of measurements performed as part of the inspection method.

The outputs of the method described herein may be used in an accuracy determination processing. The accuracy determination processing may be a processing by which an indication of a placement accuracy of the bonding tool is obtained. The placement accuracy may be the accuracy with which a donor substrate 210 can be aligned with a target portion on an acceptor substrate 220 during the placement of the donor substrate 210 onto the target portion.

The accuracy determination processing may comprise comparing output (i) above with one or both of outputs (ii) and (iii), or values derived therefrom. For example, the accuracy determination processing may comprise comparing (a) the measured location of the support structure 250 while the support structure 250 is at the imparting location (or one or more values derived therefrom), with (b) the position of the mark determined from the inspecting of the mark (or one or more values derived therefrom).

A more detailed example of an accuracy determination processing will now be described. In this example, the inspection surface is a surface of an inspection substrate supported on the support structure 250. The accuracy determination processing may comprise determining an estimated position of the imparted mark M from the measured location(s) of the support structure 250 and/or stage 202. That is, the estimated position of the imparted mark M may be determined based on the measured location of the support structure 250 while support structure 250 is at the imparting location, and the measured location of the stage 202 while the stage 202 is at the imparting location (e.g. based on outputs (ii) and (iii) above). The estimated position of the imparted mark M may be an estimated position of the imparted mark M relative to the inspection substrate (e.g. relative to a reference mark on the inspection substrate) or relative to the support structure 250.

From the measured locations of the support structure 250 and the stage 202 at their respective imparting locations, an estimate for the relative positioning between the support structure 250 and the stage 202 at the point at which the mark M is imparted to the inspection surface can be computed. The position of the inspection substrate relative to the support structure 250 may be known (see above). The position of the marker 350 relative to the stage 202 may be known (see above). Thus, from the estimated relative positioning between the support structure 250 and the stage 202 at the point at which the mark M is imparted to the inspection surface, an estimated relative positioning between the marker 350 and the inspection substrate can be obtained. The estimated relative positioning between the marker 350 and the inspection substrate is the estimated position of the imparted mark M on the inspection substrate.

The estimated position of the imparted mark M on the inspection substrate may be compared to the position of the imparted mark M as determined by inspection of the mark (e.g. using the alignment sensor). The position of the imparted mark M as determined by inspection of the mark (e.g. using the alignment sensor) may be assumed to be the true position of the mark on the inspection substrate, because inspection techniques such as the techniques used by the alignment sensor are very accurate. Thus, any discrepancy (or error) between the estimated position of the imparted mark M on the inspection substrate and the position of the imparted mark M as determined by inspection of the mark (e.g. using the alignment sensor) may be attributed to an inaccuracy in the bonding tool. Inaccuracy in the bonding tool may arise due to an inaccuracy in the positioning system for the support structure 250, and/or an inaccuracy in the measurement of the position of the stage 202.

The comparison between estimated position of the imparted mark M on the inspection substrate and the position of the imparted mark M as determined by inspection of the mark (e.g. using the alignment sensor) may comprise the computation of an error. The error may comprise various components, each component being indicative of a misalignment in a given direction (e.g. x-direction, y-direction, Rx-direction, Ry-direction).

The error may be displayed to an operator/user, such that the operator is able to take appropriate action. Thus, the placement of a donor substrate 210 on a target portion of an acceptor substrate 220 can be performed more accurately. Thus, the bonding method is improved.

Additionally or alternatively, the error may be input into a calibration processing. The calibration processing may use the error to adapt the operation of the bonding tool to improve the placement accuracy. For example, the calibration processing may use the error to adapt the operation of the positioning system for the support structure 250. This may mean that the placement of a donor substrate 210 on a target portion of an acceptor substrate 220 can be performed more accurately. Thus, the bonding method is improved.

As above, bonding tool may be configured such that the position of the stage 202 may be measured using one measurement system, and the position of the support structure 250 may be measured using another, independent measurement system (e.g. the positioning system described above). The position of the stage 202 may be measured in a different coordinate system, and/or with respect to a different reference, to the position of the support structure 250. The position of the imparted mark M as determined by inspection of the mark (e.g. using the alignment sensor) may allow the relationship between the measured position of the stage 202 and the measured position of the support structure 250 to be precisely determined.

For example, the support structure 250 may be measured to have a location in the coordinate system of the support structure 250 that is (x, y). For accurate alignment of the acceptor substrate 220 supported on the support structure 250 with the donor substrate 210 supported on the stage 202, it may be preferable that the location of the support structure in the coordinate system of the stage 202 (i.e. (X, Y)) can be accurately determined. By considering outputs (i) to (iii) above, the relationship between the coordinate system of the support structure 250 and the coordinate system of the stage 202 can be accurately derived.

Say, for example, a mark is imparted to an inspection substrate while the support structure 250 is at a position of (23, 45) in the coordinate system of the support structure. When the mark is inspected, it may be determined that the mark is imparted at a position of (5, 12) relative to a reference mark on the support structure 250. It is therefore known that, when the support structure 250 is at a position of (23, 45) in the coordinate system of the support structure, the stage 202 is aligned with the support structure 250 such that the stage 202 will place a donor substrate 210 at the position (5, 12) relative to the reference mark on the support structure. From this one measurement, it may be possible to determine a general relationship between the position of the support structure 250 in the coordinate system of the support structure 250 (as measured by the positioning system) and the position at which the stage 202 which will place a donor substrate 210. For example, where the position (in the coordinate system of the support structure 250) of the support structure relative to the coordinate system is (X, Y), the position (relative to the reference mark on the support structure 250) the position at which the stage 202 which will place a donor substrate 210 may be (X-18, Y-33). In some embodiments, this relationship may already exist, and the information obtained by the inspection of the imparted mark M may be used to adapt the relationship so that it is more accurate.

The inspection method of the present disclosure may comprise imparting a plurality of marks at the inspection surface, and then inspecting each of the plurality of marks to determine a position of each of the plurality of marks. The marks of the plurality of marks may be imparted to the inspection surface in the same way as described above. Positions of marks of the plurality of marks may be determined in the same way as described above.

To impart a plurality of marks to the inspection surface, a first mark may be imparted to the inspection surface and then a second mark may be imparted to the inspection surface. Between imparting the first and second marks, the stage 202 and the support structure 250 may move relative to one another in the x- or y-direction so that the second mark is imparted to the inspection surface at a different location to that of the first mark. The relative motion of the stage 202 and the support structure 250 may be caused by movement of the support structure 250 (e.g. by the positioning system for the support structure 250). This process (i.e. imparting a mark, causing relative movement between the stage 202 and the support structure 250, and imparting another mark) may be repeated to impart a third mark, fourth mark, fifth mark, etc. mark to the inspection surface.

A first imparting location of the stage 202 may be a location of the stage 202 when the first mark is imparted to the inspection surface. A first imparting location of the support structure 250 may be a location of the support structure 250 when the first mark is imparted to the inspection surface. A second imparting location of the stage 202 may be a location of the stage 202 when the second mark is imparted to the inspection surface. A second imparting location of the support structure 250 may be a location of the support structure 250 when the second mark is imparted to the inspection surface. The first imparting location of the stage 202, the first imparting location of the support structure 250 the second imparting location of the stage 202, and/or the second imparting location of the support structure 250 may be measured and recorded. Imparting locations for third, fourth, etc. marks may be measured and recorded in the same way.

In the case that the inspection surface is a surface of an inspection substrate supported on the support structure, the inspection surface may extend over substantially all of an upper surface of the inspection substrate (i.e. a surface of the substrate which faces the stage 202). The plurality of marks imparted to the inspection surface may be distributed across the inspection surface (e.g. substantially uniformly). The plurality of marks imparted to the inspection surface may be arranged in a two-dimensional grid extending across the inspection surface. The plurality of marks imparted to the inspection surface may comprise 10 or more marks, 100 or more marks, 1,000 or more marks, 10,000 or more marks, etc..

The accuracy determination processing described above may be performed for each of the plurality of marks imparted onto the inspection surface. This may give a plurality of error values, which differ as a function of the position on the inspection surface. That the error differs as a function of the position on the inspection surface may be a result of spatially-dependent defects in the sensors of the positioning system for the support structure 250. For example, mirrors of interferometric sensors of the positioning system may have spatially-varying degrees of curvature. That the error varies as a function of the position on the inspection surface may also be a result of the fact that the inspection substrate itself is warped and/or deformed in places.

Additionally or alternatively, the calibration processing described above may be performed for each of the plurality of marks imparted onto the inspection surface.

Additionally or alternatively, the relationship between the coordinate system of the support structure 250 and the coordinate system of the stage 202 may be derived at the position of each of the plurality of marks imparted to the inspection surface. Thus, a derived relationship between the coordinate system of the support structure 250 and the coordinate system of the stage 202 may be a function of the position on the inspection surface.

There may be alternatives to imprinting a mark on an inspection surface using a marker, and then inspecting the mark to determine the position of the mark. For example, a substrate may be placed onto the inspection surface, and then the substrate inspected to determine a position of the substrate on the inspection surface. The position of the substrate as determined by the inspection of the placed substrate could be used in a similar way to how the position of the imparted mark is used in the inspection method of the present disclosure.

However, this alternative suffers from several disadvantages. For example, when the substrate is placed onto the inspection surface the substrate may become deformed as a result of forces (e.g. Van der Waal's forces) exerted on the substrate as the substrate contacts the inspection surface. This means that the position of the substrate as determined through the inspection of the substrate is dependent on (i) the accuracy of the positioning systems of the bonding tool, and (ii) the deformation of the substrate as it is placed. It may not be possible to decouple (i) and (ii). Thus, a method which involves placing a substrate onto an inspection surface may provide information that is less useful for assessing the accuracy of positioning systems of a bonding tool and/or calibrating the positioning systems of the bonding tool. The method of the present disclosure does not involve placing a substrate onto the inspection surface, and so forces (e.g. Van der Waal's forces) exerted on the substrate as the substrate is placed onto the inspection surface are not of relevance. Thus, the method of the present disclosure may provide information that is more useful for assessing the accuracy of positioning systems of a bonding tool and/or calibrating the positioning systems of the bonding tool.

In the alternative method, it may be difficult or impossible to remove a substrate from an inspection surface after the substrate has been placed on the inspection surface. Thus, the substrate- and the component on which the inspection surface is formed (e.g. the inspection substrate or even the support structure itself)-may be single-use. Consequently, performing the alternative method may result in a large amount of waste. In the method of the present disclosure, marks can be formed in the deformable layer, and then the deformable layer can be removed. Moreover, the marker can be used over and over again, because no change happens to the marker when the marker imprints the mark. Thus, the method of the present disclosure is more economical and results in less waste.

Further embodiments of the invention are disclosed in the list of numbered clauses below:
1. A method using an apparatus, wherein the apparatus is configured to join a first substrate and a second substrate, and the apparatus comprises a stage for supporting the first substrate and a support structure for supporting the second substrate, the method comprising
   contacting an inspection surface using a marker associated with the stage to impart a mark to the inspection surface, wherein the inspection surface is a surface of a substrate supported on the support structure or a surface of the support structure;
   inspecting the mark to determine a position of the mark.
2. The method of clause 1, wherein the imparting of the mark to the inspection surface comprises imprinting the mark at the inspection surface.
3. The method of clause 2, wherein the inspection surface is formed by a deformable layer, and the imparting of the mark to the inspection surface comprises imprinting the mark in the deformable layer.
4. The method of clause 3, wherein the deformable layer comprises a layer of photoresist.
5. The method of any of the preceding clauses, wherein the determining of the position of the mark comprises determining the position of the mark relative to the support structure, optionally relative to a reference mark on the support structure.
6. The method of any of the preceding clauses, wherein the apparatus comprises a positioning system configured to position the support structure, wherein the positioning system comprises one or more position sensors configured to determine the position of the support structure, optionally wherein the positioning system comprises one or more actuators configured to move the support structure.
7. The method of clause 6, wherein the apparatus is configured such that, in the joining of the first substrate and the second substrate, the apparatus performs a processing step to determine the position of the first substrate supported on the stage relative to the second substrate supported on the support structure, and said processing is based on measurements made by the one or more position sensors of the positioning system.
8. The method of clause 6 or 7, wherein a location of the support structure when the mark is imparted to the inspection surface is an imparting location, and the method comprises recording one or more measurements made by the one or more position sensors of the positioning system while the support structure is at the imparting location.
9. The method of clause 8, further comprising comparing: (i) the one or more measurements made by the one or more position sensors while the support structure is at the imparting location, or one or more values derived therefrom, with (ii) the position of the mark determined from the inspecting of the mark, or one or more values derived therefrom.
10. The method of clause 9, wherein said comparing is to determine one or more values associated with the stage and/or the support structure.
11. The method of any of the preceding clauses, wherein the mark comprises one or more diffraction gratings.
12. The method of clause 11, wherein the inspecting of the mark comprises inspecting the one or more diffraction gratings of the mark using an interferometric measurement system.
13. The method of any of the preceding clauses, wherein the method comprises:
   imparting a plurality of marks at the inspection surface; and
   inspecting each of the plurality of marks to determine a position of each of the plurality of marks.
14. The method of any of the preceding clauses, wherein the marker comprises at least one protrusion corresponding to the mark.
15. The method of clause 14, wherein the stage comprises the marker, and/or the marker is mounted on the stage.
16. The method of clause 14 or 15 wherein the apparatus further comprises a marker substrate supported on the stage, and the marker substrate comprises the marker.
17. The method of clause 16, wherein the stage comprises one or more receiver portions each configured to support a first substrate, and the marker substrate is supported by one of the one or more receiver portions.
18. The method of clause 17, wherein the one or more receiver portions are each configured to clamp using a vacuum clamping means.
19. The method of any of the preceding clauses, wherein the stage is a rotatable stage.
20. The method of clause 19, wherein the stage comprises a plurality of receiver portions, and the stage is rotatable to align different receiver portions of the plurality of receiver portions with a second substrate supported on the substrate support.
21. The method of any of the preceding clauses, wherein contacting the inspection surface using the marker comprises moving the marker towards the support structure and/or moving the support structure towards the marker.
22. The method of any of the preceding clauses, further comprising calibrating the apparatus based on the determined position of the mark.
23. The method of clause 6, further comprising calibrating the positioning system based on the determined position of the mark.
24. The method of clause 7, further comprising calibrating said processing based on the determined position of the mark.
25. The method of clause 8, further comprising calibrating the apparatus based on (i) the one or more measurements made by the one or more position sensors while the support structure is at the imparting location, or one or more values derived therefrom, and (ii) the position of the mark determined from the inspecting of the mark, or one or more values derived therefrom.
26. The method of any of the preceding clauses, further comprising, after the inspecting of the mark, removing the deformable layer from the substrate or the substrate support.
27. The method of any of the preceding clauses, wherein:
   the apparatus comprises a bonding station and a measurement station;
   the imparting of the mark to the inspection surface is performed at the bonding station;
   and the inspecting of the mark is performed at the measurement station.
28. The method of clause 27, wherein:
   the apparatus comprises two or more support structures;
   each support structure is configured to support a second substrate; and
   the two or more support structures are configured such that one second substrate can be processed at the measurement station and another second substrate can be processed at the bonding station, simultaneously.
29. The method of any of the preceding clauses, wherein the first substrate is a donor substrate, optionally wherein the donor substrate is a die.
30. The method of any of the preceding clauses, wherein the second substrate is an acceptor substrate, optionally wherein the acceptor substrate is a wafer.
31. The method of any of the preceding clauses, wherein the inspection surface is a surface of a substrate supported on the substrate support, and wherein:
   the substrate is a test substrate, specifically adapted for use in the inspection method; or
   the substrate is a production substrate, configured to be made into an integrated circuit (IC).
32. The method of any of the preceding clauses, wherein the inspection surface is a reserved portion of a surface of the substrate support.
33. An apparatus configured to perform the method of any of the preceding clauses.
34. A computer program comprising instructions which, when executed by a processor, cause the apparatus of clause 33 to perform the method of any of clauses 1 to 32.
35. An apparatus configured to join a first substrate and a second substrate, the apparatus comprising:
   a stage for supporting the first substrate;
   a marker associated with the stage;
   a support structure for supporting the second substrate;
   a measurement system; and
   a processor,
   wherein the marker is configured to contact an inspection surface to impart a mark to the inspection surface, wherein the inspection surface is a surface of a substrate supported on the support structure or a surface of the support structure,
   wherein the measurement system is configured to inspect the mark; and
   wherein the processor is configured to determine a position of the mark based on the inspection of the mark.
36. The apparatus of clause 35, wherein the stage is configured to, using the marker, imprint a mark at the inspection surface.
37. The apparatus of clause 35 or 36, wherein the stage comprises the marker and/or the marker is mounted on the stage.
38. The apparatus of any of clauses 35 to 37, wherein the apparatus further comprises a marker substrate supported by the stage, and the marker substrate comprises the marker.
39. The apparatus of any of clauses 34 to 38, wherein the inspection surface is formed by a deformable layer, optionally wherein the deformable layer is a layer of photoresist.
40. The apparatus of any of clauses 35 to 39, wherein the inspection surface is a surface of a substrate supported on the support structure, said substrate comprises a deformable layer, , and the apparatus comprises said substrate.
41. A computer program comprising instructions which, when executed by a processor, cause the apparatus of any of clauses 35 to 40 to perform the method of any of clauses 1 to 33.

The methods of the present invention may be performed by computer systems comprising one or more computers. A computer used to implement the invention may comprise one or more processors, including general purpose CPUs, graphical processing units (GPUs), tensor processing units (TPU) or other specialised processors. A computer used to implement the invention may be physical or virtual. A computer used to implement the invention may be a server, a client or a workstation. Multiple computers used to implement the invention may be distributed and interconnected via a network such as a local area network (LAN) or wide area network (WAN). Individual steps of the method may be carried out by a computer system but not necessarily the same computer system. Results of a method of the invention may be displayed to a user or stored in any suitable storage medium. The present invention may be embodied in a non-transitory computer-readable storage medium that stores instructions to carry out a method of the invention. Any suitable programming language may be used to implement the invention. The present invention may be embodied in a computer system comprising one or more processors and memory or storage storing instructions to carry out a method of the invention.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims set out below.

## Claims

1. A method using an apparatus, wherein the apparatus is configured to join a first substrate and a second substrate, and the apparatus comprises a stage for supporting the first substrate and a support structure for supporting the second substrate, the method comprising
contacting an inspection surface using a marker associated with the stage to impart a mark to the inspection surface, wherein the inspection surface is a surface of a substrate supported on the support structure or a surface of the support structure;
inspecting the mark to determine a position of the mark.

2. The method of claim 1, wherein the imparting of the mark to the inspection surface comprises imprinting the mark at the inspection surface.

3. The method of claim 2, wherein the inspection surface is formed by a deformable layer, and the imparting of the mark to the inspection surface comprises imprinting the mark in the deformable layer.

4. The method of claim 3, wherein the deformable layer comprises a layer of photoresist.

5. The method of any of the preceding claims, wherein the determining of the position of the mark comprises determining the position of the mark relative to the support structure, optionally relative to a reference mark on the support structure.

6. The method of any of the preceding claims, wherein the apparatus comprises a positioning system configured to position the support structure, wherein the positioning system comprises one or more position sensors configured to determine the position of the support structure, optionally wherein the positioning system comprises one or more actuators configured to move the support structure.

7. The method of claim 6, wherein the apparatus is configured such that, in the joining of the first substrate and the second substrate, the apparatus performs a processing step to determine the position of the first substrate supported on the stage relative to the second substrate supported on the support structure, and said processing is based on measurements made by the one or more position sensors of the positioning system.

8. The method of claim 6 or 7, wherein a location of the support structure when the mark is imparted to the inspection surface is an imparting location, and the method comprises recording one or more measurements made by the one or more position sensors of the positioning system while the support structure is at the imparting location.

9. The method of claim 8, further comprising comparing: (i) the one or more measurements made by the one or more position sensors while the support structure is at the imparting location, or one or more values derived therefrom, with (ii) the position of the mark determined from the inspecting of the mark, or one or more values derived therefrom.

10. The method of any of the preceding claims, wherein the marker comprises at least one protrusion corresponding to the mark.

11. The method of claim 10, wherein the stage comprises the marker, and/or the marker is mounted on the stage.

12. The method of claim 10 or 11, wherein the apparatus further comprises a marker substrate supported on the stage, and the marker substrate comprises the marker.

13. An apparatus configured to join a first substrate and a second substrate, the apparatus comprising:
a stage for supporting the first substrate;
a marker associated with the stage;
a support structure for supporting the second substrate;
a measurement system; and
a processor,
wherein the marker is configured to contact an inspection surface to impart a mark to the inspection surface, wherein the inspection surface is a surface of a substrate supported on the support structure or a surface of the support structure,
wherein the measurement system is configured to inspect the mark; and
wherein the processor is configured to determine a position of the mark based on the inspection of the mark.

14. The apparatus of claim 13, wherein the stage is configured to, using the marker, imprint a mark at the inspection surface.

15. The apparatus of claim 13 or 14, wherein the stage comprises the marker and/or the marker is mounted on the stage.
